# EUROPÄISCHE PATENTSCHRIFT

(11) **EP 3 488 675 B1**
(45) Veröffentlichungstag und Bekanntmachung des Hinweises auf die Patenterteilung: **02.03.2022**
(21) Anmeldenummer: 17764638.7
(22) Anmeldetag: 18.07.2017
(51) Int. Cl.: H05K 13/04, H01L 21/683, G06K 19/077, G06K 7/00, B65H 11/00, B65H 5/22, B65H 29/32, B65H 29/24, G08B 13/24, B07C 5/36, H01L 21/677, B65G 43/08, B65G 47/52, B65G 21/20, B65G 47/91, B65G 1/137, B65G 47/08, H01L 21/67, H05K 13/02, B65H 43/04, B65H 29/62

(54) **VORRICHTUNG ZUM AUFBRINGEN VON DATENTRÄGERN AUF EINE TRÄGERBAHN**
APPARATUS FOR MOUNTING DATA CARRIERS ONTO A CARRIER WEB
DISPOSITIF DE MONTAGE DE SUPPORTS DE DONNÉES SUR UNE BANDE DE SUPPORT

(30) Priorität: 20.07.2016 DE 202016004428 U
(43) Veröffentlichungstag der Anmeldung: 29.05.2019
(73) Patentinhaber: BW Papersystems Stuttgart GmbH, 72622 Nürtingen (DE)
(72) Erfinder: NITSCHKO, Harry, 72649 Wolfschlugen (DE)
(74) Vertreter: Von Rohr Patentanwälte Partnerschaft mbB
(86) Internationale Anmeldenummer: PCT/IB2017/000840
(87) Internationale Veröffentlichungsnummer: WO 2018/015801

(56) Entgegenhaltungen:
- EP-A2- 0 906 011
- EP-A2- 1 073 325
- EP-A2- 1 096 423
- DE-A1-102005 041 024
- JP-A- S60 213 621
- KR-A- 20140 032 323
- US-A- 2 812 079
- US-A- 4 736 831

## Beschreibung

Die Erfindung betrifft eine Vorrichtung zum Aufbringen von flächigen Datenträgern auf eine durchlaufende Trägerbahn mit den Merkmalen des Oberbegriffs von Anspruch 1.

Die bekannte Vorrichtung, von der die Erfindung ausgeht (DE 44 24 429 A1), hat als Datenträger z.B. Etiketten oder sonstige Markierungsträger. Datenträger können aber auch und insbesondere passive oder aktive elektronische Datenträger sein, beispielsweise Transponder, Chips, Inlays o.dgl. (EP 1 268 283 B1). Mittels der Datenträger-Zuführeinrichtung werden die Datenträger endlos von einem Rollenspeicher aus zugeführt und dann mittels einer Querschneideinrichtung abgetrennt und so vereinzelt oder von einer die Datenträger zunächst tragenden, ebenfalls vom Rollenspeicher kommenden Basisbahn durch Ablösen vereinzelt, wobei die Basisbahn vorzugsweise durch Umlenkung aus dem Bereich der Zuführeinrichtung entfernt und vorzugsweise auf einem weiteren Rollenspeicher aufgerollt wird.

Zur ausgerichteten Zuführung der Datenträger weist die Zuführeinrichtung eine von der Antriebswalze horizontal beabstandet angeordnete Umlenkung auf, um die mindestens ein Tragband umläuft. Im Stand der Technik sind es mehrere Tragbänder, die parallel zueinander umlaufen und mittels jeweils eines Riemenspanners unter Spannung gehalten werden. Das mindestens eine Tragband bildet ein in Zuführrichtung der Datenträger im Wesentlichen horizontal verlaufendes Obertrum, das eine Transportstrecke für die Datenträger bildet. Der rücklaufende Abschnitt des Tragbandes verläuft unter dem Obertrum entgegengesetzt als Untertrum.

Auf der vom Obertrum des mindestens einen Tragbandes gebildeten Transportstrecke werden die Datenträger kontrolliert der Datenträger-Übergabeeinrichtung zugeführt. Um auf dem Obertrum des mindestens einen Transportbandes sicher zu verbleiben werden die Datenträger auf dem Obertrum mittels eines von einem Saugkasten unter dem Obertrum erzeugten Unterdruckes gehalten. Am Ende der Transportstrecke, also im Bereich der Umlenkung, werden die Datenträger auf eine Übergabewalze der Datenträger-Übergabeeinrichtung übergeben und haften dort ebenfalls wieder unter Unterdruck auf deren Außenmantel. Von diesem Zugangsbereich der Übergabewalze aus bewegen sich die Datenträger durch Drehung der Übergabewalze um einen bestimmten Winkel in einen Abgangsbereich, der sich benachbart zu der Führung einer durchlaufenden Trägerbahn befindet.

Die durchlaufende Trägerbahn wird am Abgangsbereich der Übergabewalze so geführt, dass sichergestellt ist, dass erst an einer Engstelle des von einer Leitwalze für die Trägerbahn gebildeten Durchlaufspaltes eine Berührung des zu übergebenden Datenträgers mit dem entsprechenden Abschnitt der Trägerbahn erfolgt. Der Datenträger haftet nun an der Trägerbahn und läuft mit dieser der nächsten Bearbeitungsstation zu.

Im Stand der Technik, von dem die Erfindung ausgeht, besteht keine Möglichkeit, gezielt einzelne Datenträger aus dem Durchlauf auszuschleusen. Das kann im Betrieb notwendig werden, beispielsweise wenn eine Bedienungsperson erkennt, dass ein Datenträger verrutscht ist, schief auf dem Tragband mitläuft, einen falschen Aufdruck oder einen sonstigen Fehler hat, o.dgl.

Der Lehre der vorliegenden Erfindung liegt daher das Problem zugrunde, die bekannte Vorrichtung zum Aufbringen von flächigen Datenträgern auf eine durchlaufende Trägerbahn so auszugestalten und weiterzubilden, dass auf einfache Weise ein gezieltes Ausschleusen einzelner Datenträger erfolgen kann.

Das zuvor aufgezeigte Problem ist bei einer Vorrichtung mit den Merkmalen des Oberbegriffs von Anspruch 1 durch die Merkmale des kennzeichnenden Teils von Anspruch 1 gelöst.

Erfindungsgemäß ist erkannt worden, dass die vom Obertrum des Tragbandes gebildete Transportstrecke einen optimalen Platz bietet, um von dort gezielt einzelne Datenträger vom Tragband zu entfernen. Dazu ist erfindungsgemäß am Obertrum eine Abwurfvorrichtung vorgesehen, mit der ein auf dem Obertrum befindlicher Datenträger vom Obertrum gesteuert entfernbar ist.

Im Rahmen der Lehre der Erfindung sind flächige Datenträger aller Art betroffen. Es können also die beim eingangs genannten, den Ausgangspunkt bildenden Stand der Technik primär im Blick befindlichen Etiketten sein, insbesondere sind es aber aktive oder passive elektronische flächige Datenträger. Flächig bedeutet nicht notwendig völlig plan, bei Datenträgern, die beispielsweise einen oder mehrere Chips tragen, kann sich auch auf der Grundfläche des Datenträgers die eine oder andere Erhöhung befinden.

Die durchlaufende Trägerbahn wird am Abgangsbereich der Übergabewalze so geführt, dass sichergestellt ist, dass erst an einer Engstelle des von einer Leitwalze für die Trägerbahn gebildeten Durchlaufspaltes eine Berührung des zu übergebenden Datenträgers mit dem entsprechenden Abschnitt der Trägerbahn erfolgt. Der Datenträger haftet nun an der Trägerbahn und läuft mit dieser der nächsten Bearbeitungsstation zu.

Im Stand der Technik, von dem die Erfindung ausgeht, besteht keine Möglichkeit, gezielt einzelne Datenträger aus dem Durchlauf auszuschleusen. Das kann im Betrieb notwendig werden, beispielsweise wenn eine Bedienungsperson erkennt, dass ein Datenträger verrutscht ist, schief auf dem Tragband mitläuft, einen falschen Aufdruck oder einen sonstigen Fehler hat, o.dgl.

Aus der EP 1 096 423 A2 sind ein Verfahren und eine Vorrichtung zum Erzeugen einer fehlerfreien Materialbahn bekannt, mit einer Zuführeinrichtung für eine fehlerhafte Informationsträger aufweisende Materialbahn, mit einer ersten Ausgabeeinrichtung für eine ausschließlich fehlerfreie Informationsträger aufweisende Materialbahn und wenigstens einer Erkennungsvorrichtung zum Erkennen fehlerhafter Informationsträger, wobei wenigstens eine Ablösevorrichtung zum Ablösen von Informationsträgern von der fehlerhafte Informationsträger aufweisenden Materialbahn mit dieser in Eingriff bringbar ist. Im Bereich der Ablösevorrichtung ist ein Transportelement, vorzugsweise eine Saugwalze, zur Aufnahme und zum Transport von abgelösten Informationsträgern angeordnet.

Aus der DE 10 2005 041 024 A1 ist eine Vorrichtung zum kontinuierlichen Aussondern fehlerhafter Bauelemente aus einer Menge von Bauelementen bekannt, die lösbar auf mindestens einer Trägerbahn in mindestens einer Reihe fortlaufend angeordnet sind, wobei die Trägerbahn fehlerhafte und fehlerfreie Bauelemente aufweist. Die bekannte Vorrichtung umfasst eine Kontrolleinrichtung zur Ermittlung fehlerhafter Bauelemente, eine Übernahmeeinrichtung zur Übernahme auszusondernder, fehlerhafter Bauelemente, mindestens eine Ablöseeinrichtung, die jedes Bauelement zumindest teilweise von der Trägerbahn ablöst und bezogen auf eine vorhergehende Position versetzt auf der Trägerbahn wieder aufbringt, und mindestens eine Auswahleinrichtung, die ein von der Kontrolleinrichtung als fehlerhaft ermitteltes, zumindest teilweise von der Trägerbahn abgelöstes Bauelement derart auswählt, dass dieses von der Übernahmeeinrichtung übernommen wird.

Der Lehre der vorliegenden Erfindung liegt daher das Problem zugrunde, die bekannte Vorrichtung zum Aufbringen von flächigen Datenträgern auf eine durchlaufende Trägerbahn so auszugestalten und weiterzubilden, dass auf einfache Weise ein gezieltes Ausschleusen einzelner Datenträger erfolgen kann.

Das zuvor aufgezeigte Problem ist bei einer Vorrichtung mit den Merkmalen des Oberbegriffs von Anspruch 1 durch die Merkmale des kennzeichnenden Teils von Anspruch 1 gelöst.

Erfindungsgemäß ist erkannt worden, dass die vom Obertrum des Tragbandes gebildete Transportstrecke einen optimalen Platz bietet, um von dort gezielt einzelne Datenträger vom Tragband zu entfernen. Dazu ist erfindungsgemäß am Obertrum eine Abwurfvorrichtung vorgesehen, mit der ein auf dem Obertrum befindlicher Datenträger vom Obertrum gesteuert entfernbar ist.

Im Rahmen der Lehre der Erfindung sind flächige Datenträger aller Art betroffen. Es können also die beim eingangs genannten, den Ausgangspunkt bildenden Stand der Technik primär im Blick befindlichen Etiketten sein, insbesondere sind es aber aktive oder passive elektronische flächige Datenträger. Flächig bedeutet nicht notwendig völlig plan, bei Datenträgern, die beispielsweise einen oder mehrere Chips tragen, kann sich auch auf der Grundfläche des Datenträgers die eine oder andere Erhöhung befinden.

Im Rahmen der Lehre der vorliegenden Erfindung ist im Bereich der Datenträger-Zuführeinrichtung mindestens ein umlaufendes Tragband vorgesehen, vorzugsweise sind es aber mehrere parallel laufende schmale umlaufende Tragbänder. Zwischen den Tragbändern können sich am Obertrum die Ansaugöffnungen des Saugkastens befinden. Bevorzugt wird das mindestens eine Tragband allerdings selbst Luftdurchtrittsöffnungen aufweisen, so dass die Wirkung des Saugkastens durch das mindestens eine Tragband hindurch auf die Datenträger erfolgt.

Im Einzelnen wird für die konstruktiven Lösungen für entsprechende Vorrichtungen insbesondere auf die eingangs genannte DE 44 24 429 A1, ergänzend aber auch auf die EP 1 268 283 B1 verwiesen.

Als Abwurfvorrichtung kommen vielerlei Varianten in Frage. Jede Abwurfvorrichtung muss in der Lage sein, einen im Verlauf der vom Obertrum gebildeten Transportstrecke befindlichen Datenträger selektiv und gesteuert vom Obertrum zu entfernen.

Nach einer ersten Variante der Lehre der Erfindung ist vorgesehen, dass die Abwurfvorrichtung durch einen am Saugkasten im Verlauf der vom Obertrum gebildeten Transportstrecke vorhandenen Abwurfabschnitt gebildet ist, in dem am Obertrum des Tragbandes wahlweise statt des Unterdrucks ein Überdruck erzeugbar ist, durch den ein hier befindlicher Datenträger vom Obertrum gesteuert abwerfbar ist. Hier ist die Abwurfvorrichtung in das System des Saugkastens für das Transportband integriert. An einer bestimmten Stelle am Saugkasten befindet sich der Abwurfabschnitt, in dem wahlweise und gezielt ein Überdruck erzeugt, vorzugsweise also von Unterdruck auf Überdruck umgesteuert werden kann.

Das abgegrenzte Segment am Obertrum, das den Abwurfabschnitt bildet, kann in seinen Abmessungen auf die Abmessungen eines einzelnen Datenträgers abgestimmt sein. Allerdings berücksichtigt das nicht Datenträger mit unterschiedlichen Abmessungen in Laufrichtung des Transportbandes. In einer besonders bevorzugten Variante dieser Lehre der Erfindung hat daher der Abwurfabschnitt am Saugkasten in Laufrichtung eine vergleichsweise kleine Abmessung. Unterschiedliche Abmessungen des Datenträgers, der abgeworfen werden soll, werden durch die Zeitspanne berücksichtigt, während der im Abwurfabschnitt ein Überdruck erzeugt wird. Diese Zeitspanne wird auf die Umlaufgeschwindigkeit des Tragbandes abgestimmt, so dass sich der Abwurf des gewünschten Datenträgers perfekt steuern lässt.

In einer mechanischen Variante einer Abwurfvorrichtung gemäß der Erfindung ist vorgesehen, dass die Abwurfvorrichtung schwenkbare Klappen am Tragband aufweist, wobei durch Ansteuern einer einzelnen Klappe ein auf dem Obertrum befindlicher Datenträger vom Obertrum gesteuert abwerfbar ist.

In einer weiteren mechanischen Variante einer Abwurfvorrichtung gemäß der Erfindung ist schließlich vorgesehen, dass dem Tragband im Verlauf der vom Obertrum gebildeten Transportstrecke als Abwurfvorrichtung mindestens ein Greifer und/oder Sauger zugeordnet ist, durch den ein auf dem Obertrum des Tragbandes befindlicher Datenträger vom Obertrum gesteuert abnehmbar ist.

Bereits oben ist darauf hingewiesen worden, dass eine besondere Bedeutung der vorliegenden Erfindung für aktive oder passive elektronische Datenträger vorliegt. Gemäß einer besonders bevorzugten Lehre der Erfindung ist dazu vorgesehen, dass in der Datenträger-Zuführeinrichtung oder in Zuführrichtung der Datenträger vor der Datenträger-Zuführeinrichtung eine Datenträger-Prüfeinrichtung angeordnet ist. Hier ist jeder einzelne dort durchlaufende Datenträger prüfbar. Mittels einer Steuerung ist dann ein von der Prüfeinrichtung als fehlerhaft erkannter Datenträger am Abwurfabschnitt vom Obertrum entfernbar.

Im Stand der Technik der EP 1 268 283 B1 handelt es sich beim Datenträger um einen Transponder und bei der Datenträger-Prüfeinrichtung um eine entsprechend dazu passende Konstruktion. Dabei kann jede Art der Prüfung vorgesehen werden, von einer reinen Präsenzprüfung hin bis zu einer mehrstufigen Frage/Antwort-Prüfung der verschiedenen Funktionen eines solchen Datenträgers.

Wesentlich ist, dass die Datenträger-Prüfeinrichtung in Zuführrichtung der Datenträger so angeordnet sind, dass für die insoweit vorzusehende Steuerung der Vorrichtung genügend Zeit bleibt, um die Ergebnisse der Prüfung auszuwerten und dann evtl. das Entfernen eines als fehlerhaft erkannten Datenträgers auszulösen. Besonders bevorzugt befindet sich die Datenträger-Prüfeinrichtung innerhalb der Datenträger-Zuführeinrichtung und ganz besonders bevorzugt ebenfalls im Bereich der Transportstrecke am Obertrum des Tragbandes.

Bei der besonders bevorzugten Variante mit dem Abwurfabschnitt am Saugkasten muss die Datenträger-Prüfeinrichtung in Zuführrichtung der Datenträger vor diesem Abwurfabschnitt angeordnet sein.

Bei der Variante mit Klappen am Obertrum lässt sich die notwendige zeitliche Abfolge durch die Steuerung der Vorrichtung realisieren.

Bei der Realisierung der Abwurfvorrichtung in mechanischer Hinsicht durch Greifer und/oder Sauger ist wiederum vorzusehen, dass die Datenträger-Prüfeinrichtung in Zuführrichtung der Datenträger vor dieser mechanischen Abwurfvorrichtung angeordnet ist.

Auch bei der erfindungsgemäßen Vorrichtung sind die typischen Vereinzelungskonstruktionen des Standes der Technik verwendbar, also eine Querschneideinrichtung oder eine Trenneinrichtung.

Im Übrigen gibt es verschiedene Möglichkeiten, die Konstruktion der Vorrichtung insgesamt in Hinsicht auf eine optimale Führung und Übergabe der Datenträger zu gewährleisten. Besondere Bedeutung kommt dabei einer Konstruktion zu, bei der die Übergabewalze der Datenträger-Übergabeeinrichtung gleichzeitig die Antriebswalze der Datenträger-Zuführeinrichtung ist. In diesem Fall läuft das mindestens eine Tragband komplett um die Übergabewalze der Übergabeeinrichtung. Dadurch bleiben die Datenträger während der gesamten Bewegung von dem Anfang der Datenträger-Zuführeinrichtung bis zum Abgangsbereich der Datenträger-Übergabeeinrichtung an ein und derselben Stelle auf dem durchlaufenden mindestens einen Tragband. Das ist für die Präzision des Transports der Datenträger durch die Vorrichtung eine besonders zweckmäßige Lösung.

Diese Lösung kann man auch mit einer horizontalen Transportstrecke kombinieren, so dass es dann zwei Tragbänder und zwei Transportstrecken gibt.

Insgesamt dient die erfindungsgemäße Vorrichtung dazu, eine Trägerbahn mit Datenträgern zu erzeugen, die frei von fehlerhaften Datenträgern ist. Wichtig ist dabei, dass ausnahmslos alle in der Trägerbahn realisierten Endprodukte einen fehlerfreien Datenträger besitzen. Es dürfen also auch keine Lücken auf der Trägerbahn vorliegen, in denen kein Datenträger angeordnet ist. Dies wird bei einer Vorrichtung der in Rede stehenden Art dadurch realisiert, dass mittels der Übergabeeinrichtung durch entsprechendes Takten oder Pausieren der miteinander an der Übergabeeinrichtung zusammenlaufenden Beteiligten auf der Trägerbahn durchweg funktionstüchtige Datenträger ohne Lücke angeordnet werden.

Im Folgenden wird die Erfindung anhand einer lediglich bevorzugte Ausführungsbeispiele darstellenden Zeichnung näher erläutert. In der Zeichnung wird in jeder Figur stets nur der Kernbereich der erfindungsgemäßen Vorrichtung gezeigt. Zur Vorrichtung insgesamt gehören auch noch weitere Stationen sowohl in Zuführrichtung der Datenträger vor der Datenträger-Zuführeinrichtung als auch in Ablaufrichtung der Trägerbahn nach der Datenträger-Übergabeeinrichtung. Darauf kommt es aber für die Lehre der Erfindung nicht an, so dass diese Teile einer entsprechenden Vorrichtung hier nicht dargestellt sind und auch nicht zum Schutzgegenstand gehören.

In der Zeichnung zeigt
- Fig. 1: in einer schematischen Darstellung in einer Seitenansicht ein erstes Ausführungsbeispiel einer erfindungsgemäßen Vorrichtung,
- Fig. 2: in einer schematischen Darstellung in einer Seitenansicht ein zweites Ausführungsbeispiel einer erfindungsgemäßen Vorrichtung,
- Fig. 3: in einer schematischen Darstellung in einer Seitenansicht ein drittes Ausführungsbeispiel einer erfindungsgemäßen Vorrichtung,
- Fig. 4: in einer schematischen Darstellung in einer Seitenansicht ein viertes Ausführungsbeispiel einer erfindungsgemäßen Vorrichtung.

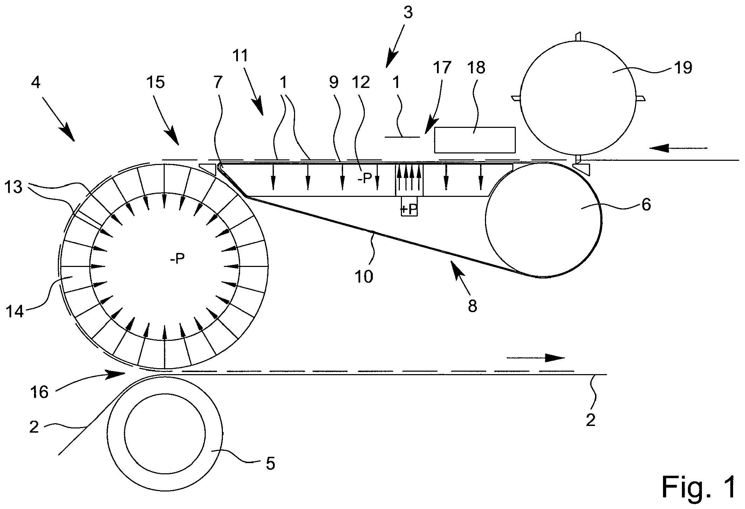

Alle Figuren zeigen einheitlich den für die Erfindung wesentlichen Teil einer Vorrichtung zum Aufbringen von flächigen Datenträgern 1 auf eine durchlaufende Trägerbahn 2. Die Trägerbahn 2 kommt von links unten in Fig. 1. Sie wird beispielsweise von einer Vorratsrolle, die in Fig. 1 nicht dargestellt ist, mittels eines Antriebsrollenpaars abgezogen.

Die Vorrichtung hat eine Datenträger-Zuführeinrichtung 3, eine Datenträger-Übergabeeinrichtung 4 und eine Trägerbahn-Anstelleinrichtung 5.

Die Trägerbahn-Anstelleinrichtung 5 ist hier als motorisch anstellbare Umlenkwalze für die Trägerbahn 2 ausgebildet, durch die die Trägerbahn 2 in Fig. 1 horizontal nach rechts umlenkbar ist. Im Anschluss an das in Fig. 1 rechts liegende angeschnittene Ende der Trägerbahn 2 folgen weitere Bearbeitungsstationen der Vorrichtung, insbesondere dort auch eine Transport- oder Abzugstation. Die Anstellung für die Trägerbahn 2 kann beispielsweise motorisch, aber auch pneumatisch oder hydraulisch erfolgen.

Die Datenträger-Zuführeinrichtung 3 weist im in Fig. 1 dargestellten Ausführungsbeispiel eine Antriebswalze 6 sowie eine von der Antriebswalze 6 beabstandet angeordnete Umlenkung 7 auf. Die Umlenkung 7 ist hier als passive Umlenkkontur ausgebildet, kann aber ebenfalls als Walze ausgeführt sein. Die Umlenkung 7 ist von der Antriebswalze 6 im Wesentlichen horizontal beabstandet. Das bedeutet, wie in Fig. 1 dargestellt, dass die Oberkante der Umlenkung 7 etwa in derselben Höhe wie die Oberkante der Antriebswalze 6 liegt.

Die Datenträger-Zuführeinrichtung 3 weist ferner mindestens ein um Antriebswalze 6 und Umlenkung 7 umlaufendes Tragband 8 auf. Vorzugsweise sind mehrere parallel zueinander laufende Tragbänder 8 vorgesehen. Das mindestens eine Tragband 8 wird vorzugsweise unter Spannung geführt, dazu kann beispielsweise eine bekannte Riemenspannvorrichtung vorgesehen sein, die allerdings in Fig. 1 nicht dargestellt ist.

Das Tragband 8 hat aufgrund seiner Führung um Antriebswalze 6 und Umlenkung 7 ein in Zuführrichtung der Datenträger 1, in Fig. 1 mit einem Pfeil dargestellt, im Wesentlichen horizontal verlaufendes Obertrum 9 sowie ein darunter entgegengesetzt verlaufendes Untertrum 10. Das Obertrum 9 bildet eine Transportstrecke 11 für die Datenträger 1. Es ist mit einem darunter angeordneten Saugkasten 12 derart hydraulisch verbunden, dass auf dem Obertrum 9 befindliche Datenträger 1 durch Unterdruck an das Tragband 8 ansaugbar sind. Der Saugkasten 12 ist an eine den Unterdruck erzeugende Saugpumpe angeschlossen, die in Fig. 1 nicht dargestellt ist.

In Fig. 1 sieht man auf dem Obertrum 9 des Tragbandes 8 die dort aufliegenden Datenträger 1, die auf dem Tragband 8 durch Unterdruck gehalten werden. Der Unterdruck ist durch die nach unten gerichteten Pfeile und das Symbol "-P" repräsentiert.

Die Datenträger-Übergabeeinrichtung 4 weist eine auf dem Umfang mit Ansaugöffnungen 13 versehene Übergabewalze 14 auf, die mit einer Unterdruckquelle derart hydraulisch verbunden ist, dass auf deren Außenmantel befindliche Datenträger 1 durch den Unterdruck an den Außenmantel ansaugbar sind. In Fig. 1 sieht man die Datenträger 1 unmittelbar auf dem Außenmantel der Übergabewalze 14. Der durch die Ansaugöffnungen 13 erzeugte Unterdruck ist durch radial nach innen gerichtete Pfeile und das Symbol "-P" gekennzeichnet.

Die Übergabewalze 14 weist einen dem Saugkasten 12 der Zuführeinrichtung 3 benachbarten Zugangsbereich 15 und einen vom Zugangsbereich 15 um einen bestimmten Winkel, hier einen Winkel von etwa 180°, beabstandeten, der Trägerbahn-Anstelleinrichtung 5 benachbarten Abgangsbereich 16 auf.

Man sieht in Fig. 1, dass die Datenträger 1 durch Drehung der Antriebswalze 6 vom oberen Zugangsbereich 15 nach unten zum Abgangsbereich 16 transportiert werden.

Am Abgangsbereich 16 der Übergabewalze 14 ist ein dort auf dem Außenmantel der Übergabewalze 14 befindlicher Datenträger 1 auf die Trägerbahn 2 übergebbar. Das sieht man am Durchlaufspalt zwischen dem Abgangsbereich 16 der Übergabewalze 14 und der Oberseite der die Anstelleinrichtung 5 bildenden Walze.

Die Datenträger 1 können auf der in Fig. 1 im Zugangsbereich 15 oben und im Abgangsbereich 16 unten liegenden Seite mit einer Haftschicht versehen sein, so dass sie in der Trägerbahn-Anstelleinrichtung 5 an der dort durchgezogenen Trägerbahn 2 anhaften. Im dargestellten und hier bevorzugten Ausführungsbeispiel sind allerdings die Datenträger 1 nicht haftend ausgeführt. Das ist nicht erforderlich, denn sie werden von einer zulaufenden Datenträger-Bahn einfach abgelängt. In diesem Fall ist jedoch die Trägerbahn 2 ist auf ihrer Oberseite gemäß Fig. 1 haftend ausgeführt, so dass die an dem Außenumfang der Übergabewalze 14 durch Unterdruck anhaftenden Datenträger 1 im Bereich der Trägerbahn-Anstelleinrichtung 5, also am Abgangsbereich 16 der Übergabewalze 14, an der Trägerbahn 2 so stark anhaften, dass die hydraulische Ansaugkraft an der Übergabewalze 14 überwunden wird. Haftend kann klebend bedeuten, aber evtl. auch anders, z.B. elektrostatisch, realisiert sein. Grundsätzlich kann auch beides realisiert sein, also Datenträger 1 und Trägerbahn 2 haftend ausgerüstet.

Die die Anstelleinrichtung 5 bildende Walze kann kontinuierlich laufen oder sie kann auch mittels eines Anstellantriebs immer wieder punktuell an die Übergabewalze 14 im Abgangsbereich 16 angestellt werden, um jeweils gezielt einen Datenträger 1 mit der Trägerbahn 2 zu verbinden. Hierzu sind im Stand der Technik eine Vielzahl von Varianten der Ansteuerung bekannt, auf die hier hingewiesen werden darf.

Insgesamt kann die Vorrichtung kontinuierlich durchlaufend oder getaktet betrieben werden, auch hierzu gibt es Beispiele im Stand der Technik. Besonders bevorzugt ist aber ein getakteter Betrieb der Vorrichtung aus den einleitend im allgemeinen Teil der Beschreibung erläuterten Gründen.

Erfindungsgemäß ist nun vorgesehen, dass am Obertrum 9 eine Abwurfvorrichtung vorgesehen ist, mit der ein auf dem Obertrum 9 befindlicher Datenträger 1 vom Obertrum 9 gesteuert entfernbar ist. Das bevorzugte Ausführungsbeispiel zeigt eine pneumatische Abwurfvorrichtung. Grundsätzlich sind aber auch mechanische Abwurfvorrichtungen denkbar.

In einer ersten, in der Zeichnung allerdings nicht dargestellten Variante hat die Abwurfvorrichtung schwenkbare Klappen am Tragband 8. Durch Ansteuern einer einzelnen Klappe kann ein auf dem Obertrum 9 befindlicher Datenträger 1 vom Obertrum 9 gesteuert abgeworfen werden. In einer zweiten, in der Zeichnung ebenfalls nicht dargestellten Variante hat die Abwurfvorrichtung eine mechanische Klappe, die sich zwischen den mehreren parallel laufenden Tragbändern 8 am Obertrum 9 befindet. Diese Klappe kann zwischen den weiter durchlaufenden Tragbändern 8 hindurch hochgeschwenkt werden und dadurch den Datenträger 1 vom Obertrum 9 abwerfen. Diese Klappe ist ortsfest angeordnet, muss also nicht mit dem Tragband 8 umlaufen.

In einer anderen mechanischen Variante ist dem Tragband 8 als Abwurfvorrichtung mindestens ein Greifer und/oder Sauger zugeordnet. Ein auf dem Obertrum 9 des Tragbandes 8 befindlicher Datenträger 1 ist mittels des Greifers und/oder Saugers vom Obertrum 9 gesteuert abnehmbar und wird so vom Tragband 8 gezielt entfernt.

Für eine bevorzugte pneumatische Abwurfvorrichtung zeigt Fig. 1 nun, dass am Saugkasten 12 im Verlauf der vom Obertrum 9 gebildeten Transportstrecke 11 ein Abwurfabschnitt 17 vorhanden ist, in dem am Obertrum 9 des Tragbandes 8 wahlweise ein Überdruck erzeugbar ist, durch den ein hier befindlicher Datenträger 1 vom Obertrum 9 gesteuert abwerfbar ist. Im in Fig. 1 erkennbaren Abwurfabschnitt 17 kann der am Obertrum 9 anliegende Druck aus dem Saugkasten 12 ein Unterdruck sein (-P). Es kann sich aber im Bedarfsfall auch um einen Überdruck handeln, dargestellt durch die nach oben gerichteten Pfeile und das Zeichen "+P". Dieser kann durch eine zusätzliche Druckquelle, also einen Überdruckerzeuger, wahlweise erzeugt werden. Er kann dann erzeugt werden, wenn ein bestimmter Datenträger 1 von dem Tragband 8 aus abgeworfen, also aus der Vorrichtung ausgeschleust bzw. entfernt werden soll.

Die bis jetzt beschriebene Vorrichtung ist für Datenträger 1 aller Art anwendbar, also auch dann, wenn ein Ausschleusen der Datenträger 1 beispielsweise durch eine optische Kontrolle einer Bedienungsperson initiiert wird.

Besondere Bedeutung hat die Lehre der Erfindung dann, wenn es sich bei den Datenträgern 1 um passive oder aktive elektronische Datenträger 1, beispielsweise Transponder, handelt.

Das in Fig. 1 dargestellte und bevorzugte Ausführungsbeispiel zeigt, insoweit für alle Datenträger 1 anwendbar, besonders geeignet aber für aktive oder passive elektronische Datenträger 1, dass in der Datenträger-Zuführeinrichtung 3 (wie hier konkret dargestellt) oder in Zuführrichtung der Datenträger 1 vor der Datenträger-Zuführeinrichtung 3 und hier auch in Zuführrichtung der Datenträger 1 vor dem Abwurfabschnitt 17 eine Datenträger-Prüfeinrichtung 18 angeordnet ist, mit der jeder einzelne dort durchlaufende Datenträger 1 prüfbar ist. Mittels einer Steuerung ist ein von der Prüfeinrichtung 18 als fehlerhaft erkannter Datenträger 1 am Abwurfabschnitt 17 vom Obertrum 9 entfernbar ist.

Die in Fig. 1 nicht weiter dargestellte Steuerung ist erforderlich, um die Abläufe der Vorrichtung insgesamt zu steuern. Insoweit darf auf den eingangs erläuterten Stand der Technik, insbesondere aus der EP 1 268 283 B1, verwiesen werden.

Mittels der Datenträger-Prüfeinrichtung 18 wird festgestellt, ob der Datenträger 1 in Ordnung ist. Das kann beispielsweise eine optische Prüfung eines passiven, nicht elektronischen Datenträgers 1 sein, beispielsweise hinsichtlich seiner Existenz und/oder Positionierung auf dem Tragband 8.

Insbesondere von Bedeutung ist eine Datenträger-Prüfeinrichtung 18 bei aktiven oder passiven elektronischen Datenträgern 1, insbesondere bei Transpondern wie beispielsweise RFID-Chips, Inlays o.dgl. Auch insoweit wird auf den zuvor genannten Stand der Technik verwiesen.

Im in Fig. 1 dargestellten Ausführungsbeispiel sitzt die Datenträger-Prüfeinrichtung 18 im Bereich der Datenträger-Zuführeinrichtung 3 selbst und in Zuführrichtung der Datenträger 1 knapp vor dem Abwurfabschnitt 17 der Transportstrecke 11. Der Abstand ist so bemessen, dass die Auswertung der Prüfdaten des jeweiligen Datenträgers 1 so schnell geht, dass die Ansteuerung auf Überdruck im Abwurfabschnitt 17 genau passend zu dem entsprechenden Datenträger 1 erfolgt, wenn das notwendig sein sollte.

Im Prinzip kann die Datenträger-Prüfeinrichtung 18 in Zuführrichtung der Datenträger 1 auch wesentlich weiter vorne, also weiter rechts in Fig. 1, angeordnet sein. Wesentlich ist jedenfalls, dass die Zeit, die der betroffene Datenträger 1 von der Datenträger-Prüfeinrichtung 18 bis zum Abwurfabschnitt 17 benötigt, in der Steuerung entsprechend berücksichtigt wird. Die Steuerung kann auch die Zeitdauer, in der im Abwurfabschnitt 17 ein Überdruck erzeugt wird, nach Maßgabe der in Laufrichtung relevanten Abmessung des Datenträgers 1 steuern. Der Abwurfabschnitt 17 könnte dann in Laufrichtung deutlich kürzer sein als in der Zeichnung dargestellt. Je nach Abmessung des Datenträgers 1 würde der Abwurfabschnitt 17 einfach kürzer oder länger mit Überdruck beaufschlagt.

Für die mechanischen Abwurfvorrichtungen, die zuvor und im allgemeinen Teil der Beschreibung erläutert worden sind, gelten entsprechende Überlegungen.

Das in Fig. 1 dargestellte und insoweit bevorzugte Ausführungsbeispiel zeichnet sich dadurch aus, dass in Zuführrichtung der Datenträger 1 am Anfang der Datenträger-Zuführeinrichtung 3 eine Querschneideinrichtung 19 angeordnet ist, mit der die als Datenträgerbahn 2 zusammenhängend einlaufenden Datenträger 1 vereinzelbar sind. Dies entspricht der Technik, die aus der den Stand der Technik bildenden Quelle DE 44 24 429 A1, aber auch aus der EP 1 268 283 B1 bekannt ist.

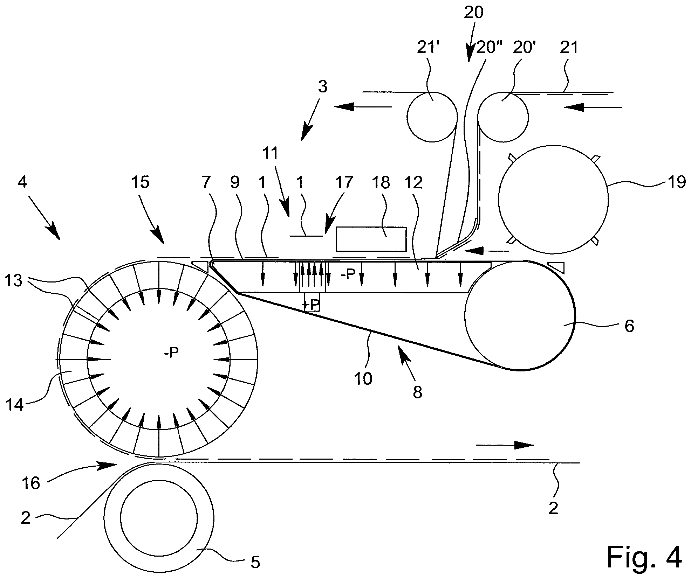

Die in Fig. 4 dargestellte Variante hat eine Konstruktion zum Gegenstand, bei der vorgesehen ist, dass in Zuführrichtung der Datenträger 1 am Anfang der Datenträger-Zuführeinrichtung 3 eine Trenneinrichtung 20 mit Umlenkrolle 20' und Trennplatte 20" angeordnet ist, mit der die auf einer zusammenhängenden Basisbahn 21 einzeln lösbar aufgebrachten Datenträger 1 von der Basisbahn 21 abtrennbar und auf dem Obertrum 9 ablegbar sind. Dies ist eine Technik, bei der die Datenträger 1 bereits vereinzelt auf einer zusammenhängenden Basisbahn 21 angeordnet sind und von dieser dann einzeln gelöst und auf dem Obertrum 9 abgelegt werden. Die Basisbahn 21 selbst wird dann zu einer Vorratsrolle 21' hin aufgewickelt.

Mit der in Fig. 1 dargestellten Konstruktion ist es möglich, auf einfache Weise, nämlich unter Nutzung der ohnehin vorhandenen Transportstrecke 11, ein Entfernen nicht brauchbarer Datenträger 1 zu realisieren. Entsprechendes gilt für die Variante von Fig. 4.

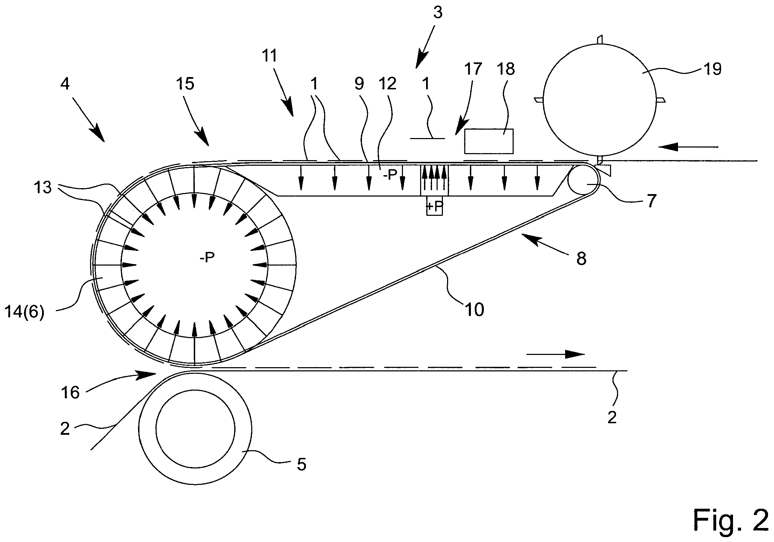

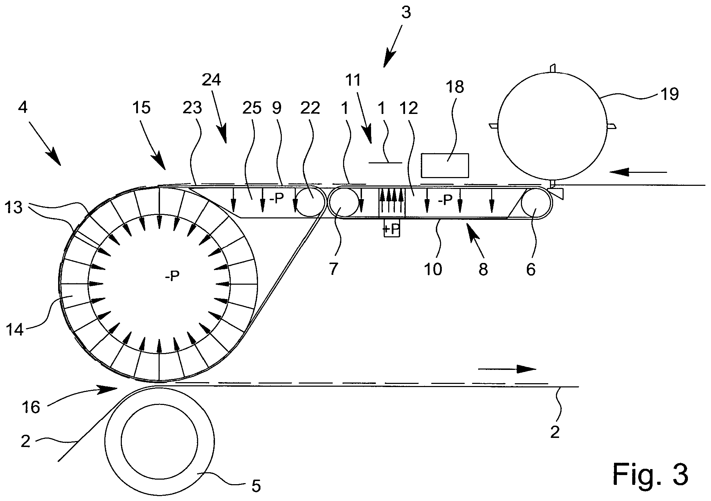

Den gleichen Vorteil haben auch die Varianten von Fig. 2 und 3, bei der die Konstruktion der Vorrichtung allerdings ein wenig anders gewählt worden ist.

Bei der Konstruktion aus Fig. 2 ist vorgesehen, dass die Übergabewalze 14 der Datenträger-Übergabeeinrichtung 4 gleichzeitig die Antriebswalze 6 der Datenträger-Zuführeinrichtung 3 ist. Gleiche Bezugszeichen sind verwendet worden für die gleichen Bauteile wie bei Fig. 1.

Man erkennt in Fig. 2, dass das Tragband 8 hier einen wesentlich längeren Weg zurücklegt als bei der Konstruktion, die in Fig. 1 dargestellt ist. Das hat damit zu tun, dass das Tragband 8 hier die Übergabewalze 14 der Datenträger-Übergabeeinrichtung 4 umschlingt. Am gegenüberliegenden Ende ist die Umlenkung 7 als Umlenkwalze ausgeführt. Durch diese Konstruktion wirkt der Unterdruck im Inneren der Übergabewalze 14 (dargestellt durch "-P") durch das mindestens eine auf dem Umfang der Übergabewalze 14 geführte Tragband 8 hindurch auf die Datenträger 1. Ein Datenträger 1, der am Eingang der Datenträger-Zuführeinrichtung 3, hier also in Zuführrichtung unmittelbar hinter der Querschneideinrichtung 19, auf dem Tragband 8 angekommen ist, bleibt an dieser Stelle des Tragbandes 8 über die gesamte Transportstrecke 13 hinweg und auf dem gesamten relevanten Teilbereich des Umfanges der Übergabewalze 14 bis zum Abgangsbereich 16. Es gibt keine zwischenzeitlichen Übergabestellen, die die Position des Datenträgers 1 auf dem Tragband 8 ungünstig beeinflussen könnten. Somit ist dies eine ganz besonders zweckmäßige Konstruktion.

Fig. 3 zeigt eine weitere Variante, die eine Kombination der Varianten aus Fig. 1 und Fig. 2 darstellt. Gleiche Bezugszeichen für gleiche Bauteile gelten auch hier.

Bei der Variante von Fig. 3 ist vorgesehen, dass die Übergabewalze 14 der Datenträger-Übergabeeinrichtung 4 zusammen mit einer von der Übergabewalze 14 entgegen der Zuführrichtung der Datenträger 1 im Wesentlichen horizontal beabstandet angeordneten zweiten Umlenkung 22 und einem um beide umlaufenden zweiten Tragband 23 eine zweite Transportstrecke 24 für die Datenträger 1 bildet, die sich in Zuführrichtung der Datenträger 1 an die erste Transportstrecke 11 anschließt. Die erste Umlenkung 7 ist hier auch eine Umlenkwalze. Die Antriebswalze 6 und die Umlenkung 7 können ihren Platz auch tauschen, sie sind hier gleichwertig.

Die Übergabe vom ersten Tragband 8 auf das zweite Tragband 23 erfolgt hier im Bereich einer weiter geführten horizontalen Transportstrecke 24, dieser Übergang ist also sehr fehlersicher. Im Bereich der Übergabewalze 14 besteht hier derselbe Vorteil wie beim Ausführungsbeispiel von Fig. 2, dass nämlich das mindestens eine Tragband 23 auch hier die Übergabewalze 14 komplett umschlingt. Insgesamt gilt auch hier natürlich, dass vorzugsweise mehrere parallel laufende Tragbänder 23 vorgesehen sind.

Generell gilt, dass das mindestens eine Tragband 8; 23 vorzugsweise mit Durchlassöffnungen für Luft versehen ist, so dass der Unterdruck am Saugkasten 12, am zweiten Saugkasten 25 und an der Übergabewalze 14 immer durch das mindestens eine Tragband 8 hindurch auf die Datenträger 1 wirkt, also mehr oder weniger vollflächig auf die Datenträger 1 wirkt.

### Bezugszeichenliste:

- 1: Datenträger
- 2: Trägerbahn
- 3: Datenträger-Zuführeinrichtung
- 4: Datenträger-Übergabeeinrichtung
- 5: Trägerbahn-Anstelleinrichtung
- 6: Antriebswalze
- 7: Umlenkung
- 8: Tragband
- 9: Obertrum
- 10: Untertrum
- 11: erste Transportstrecke
- 12: Saugkasten
- 13: Ansaugöffnung
- 14: Übergabewalze
- 15: Zugangsbereich
- 16: Abgangsbereich
- 17: Abwurfabschnitt
- 18: Datenträger-Prüfeinrichtung
- 19: Querschneideinrichtung
- 20: Trenneinrichtung
- 20': Umlenkrolle
- 20": Trennplatte
- 21: Basisbahn
- 21': Vorratsrolle
- 22: zweite Umlenkung
- 23: zweites Tragband
- 24: zweite Transportstrecke
- 25: zweiter Saugkasten

## Patentansprüche

1. Vorrichtung zum Aufbringen von flächigen Datenträgern (1) auf eine durchlaufende Trägerbahn (2), mit
einer Datenträger-Zuführeinrichtung (3),
einer Datenträger-Übergabeeinrichtung (4) und
einer Trägerbahn-Anstelleinrichtung (5),
wobei die Zuführeinrichtung (3) eine Antriebswalze (6), eine von der Antriebswalze (6) im Wesentlichen horizontal beabstandet angeordnete Umlenkung (7) und mindestens ein um Antriebswalze (6) und Umlenkung (7) umlaufendes Tragband (8) zum Zuführen von Datenträgern (1) zur Datenträger-Übergabeeinrichtung (4) aufweist,
wobei das Tragband (8) ein in Zuführrichtung der Datenträger (1) im Wesentlichen horizontal verlaufendes Obertrum (9) und ein darunter entgegengesetzt verlaufendes Untertrum (10) aufweist,
wobei das Obertrum (9) eine Transportstrecke (11) für den Transport der Datenträger (1) zur Datenträger-Übergabeeinrichtung (4) bildet und mit einem darunter angeordneten Saugkasten (12) derart hydraulisch verbunden ist, dass auf dem Obertrum (9) befindliche Datenträger (1) durch Unterdruck an das Tragband (8) ansaugbar sind,
wobei am Ende der Transportstrecke (11) die Datenträger (1) an die Datenträger-Übergabeeinrichtung (4) übergeben werden,
wobei die Übergabeeinrichtung (4) eine auf dem Umfang mit Ansaugöffnungen (13) versehene Übergabewalze (14) aufweist, die mit einer Unterdruckquelle derart hydraulisch verbunden ist, dass auf dem Außenmantel der Übergabewalze (14) befindliche Datenträger (1) durch Unterdruck an den Außenmantel ansaugbar sind,
wobei die Übergabewalze (14) einen dem Saugkasten (12) der Zuführeinrichtung (3) benachbarten Zugangsbereich (15) und ein vom Zugangsbereich (15) um einen bestimmten Winkel beabstandeten, der Anstelleinrichtung (5) benachbarten Abgangsbereich (16) aufweist und
wobei am Abgangsbereich (16) der Übergabewalze (14) ein dort auf dem Außenmantel der Übergabewalze (14) befindlicher Datenträger (1) auf die Trägerbahn (2) übergebbar ist,
wobei am Obertrum (9) eine Abwurfvorrichtung in Zuführrichtung der Datenträger (1) vor der Datenträger-Übergabevorrichtung (4) vorgesehen ist, mit der ein auf dem Obertrum (9) befindlicher Datenträger (1) vom Obertrum (9) gesteuert entfernbar ist.

2. Vorrichtung nach Anspruch 1, **dadurch gekennzeichnet,**
**dass** die Abwurfvorrichtung durch einen am Saugkasten (12) im Verlauf der vom Obertrum (9) gebildeten Transportstrecke (11) vorhandenen Abwurfabschnitt (17) gebildet ist, in dem am Obertrum (9) des Tragbandes (8) wahlweise ein Überdruck, vorzugsweise statt des Unterdrucks ein Überdruck, erzeugbar ist, durch den ein hier befindlicher Datenträger (1) vom Obertrum (9) gesteuert abwerfbar ist.

3. Vorrichtung nach Anspruch 1, **dadurch gekennzeichnet,**
**dass** die Abwurfvorrichtung schwenkbare Klappen am Tragband (8) aufweist, wobei durch Ansteuern einer einzelnen Klappe ein auf dem Obertrum (9) befindlicher Datenträger (1) vom Obertrum (9) gesteuert abwerfbar ist, oder
**dass** die Abwurfvorrichtung ortsfest am Obertrum (9) zwischen zwei Tragbändern (8) ortsfest eine schwenkbare Klappe aufweist, wobei durch Ansteuern dieser Klappe ein an dieser Stelle auf dem Obertrum (9) befindlicher Datenträger (1) vom Obertrum (9) gesteuert abwerfbar ist.

4. Vorrichtung nach Anspruch 1, **dadurch gekennzeichnet,**
**dass** dem Tragband (8) im Verlauf der vom Obertrum (9) gebildeten Transportstrecke (11) als Abwurfvorrichtung mindestens ein Greifer und/oder Sauger zugeordnet ist, durch den ein auf dem Obertrum (9) des Tragbandes (8) befindlicher Datenträger (1) vom Obertrum (9) gesteuert abnehmbar ist.

5. Vorrichtung nach einem der Ansprüche 1 bis 4, **dadurch gekennzeichnet,**
**dass** in der Datenträger-Zuführeinrichtung (3) oder in Zuführrichtung der Datenträger (1) vor der Datenträger-Zuführeinrichtung (3) eine Datenträger-Prüfeinrichtung (18) angeordnet ist, mit der jeder einzelne dort durchlaufende Datenträger (1) prüfbar ist, und dass mittels einer Steuerung ein von der Prüfeinrichtung (18) als fehlerhaft erkannter Datenträger (1) vom Obertrum (9), vorzugsweise am Abwurfabschnitt (17), entfernbar ist.

6. Vorrichtung nach einem der Ansprüche 1 bis 5, **dadurch gekennzeichnet,**
**dass** in Zuführrichtung der Datenträger (1) am Anfang der Datenträger-Zuführeinrichtung (3) eine Querschneideinrichtung (19) angeordnet ist, mit der die als Datenträgerbahn (2) zusammenhängend einlaufenden Datenträger (1) vereinzelbar sind.

7. Vorrichtung nach einem der Ansprüche 1 bis 5, **dadurch gekennzeichnet,**
**dass** in Zuführrichtung der Datenträger (1) am Anfang der Datenträger-Zuführeinrichtung (3) eine Trenneinrichtung (20) angeordnet ist, mit der die auf einer zusammenhängenden Basisbahn (21) einzeln lösbar angebrachten Datenträger (1) von der Basisbahn (21) abtrennbar und auf dem Obertrum (9) des Tragbandes (8) ablegbar sind.

8. Vorrichtung nach einem der Ansprüche 1 bis 7, **dadurch gekennzeichnet,**
**dass** die Übergabewalze (14) der Datenträger-Übergabeeinrichtung (4) gleichzeitig die Antriebswalze (6) der Datenträger-Zuführeinrichtung (3) ist.

9. Vorrichtung nach einem der Ansprüche 1 bis 7, **dadurch gekennzeichnet,**
**dass** die Übergabewalze (14) der Datenträger-Übergabeeinrichtung (4) zusammen mit einer von der Übergabewalze (14) entgegen der Zuführrichtung der Datenträger (1) im Wesentlichen horizontal beabstandet angeordneten zweiten Umlenkung (22) und mit einem um beide umlaufenden zweiten Tragband (23) eine zweite Transportstrecke (24) für die Datenträger (1) bildet, die sich in Zuführrichtung der Datenträger (1) an die erste Transportstrecke (11) anschließt.

## Claims

1. Device for applying flat data carriers (1) to a continuous carrier web (2), having
a data carrier feeding device (3),
a data carrier transfer device (4) and
of a carrier web adjusting device (5),
wherein the feed device (3) has a drive roller (6), a deflection (7) arranged at a substantially horizontal distance from the drive roller (6) and at least one carrier belt (8) running around the drive roller (6) and deflection (7) for feeding data carriers (1) to the data carrier transfer device (4),
wherein the carrier belt (8) has an upper run (9) extending substantially horizontally in the feed direction of the data carriers (1) and a lower run (10) extending oppositely thereto,
wherein the upper run (9) forms a transport path (11) for transporting the data carriers (1) to the data carrier transfer device (4) and is hydraulically connected to a suction box (12) arranged therebelow in such a way that data carriers (1) located on the upper run (9) can be sucked onto the carrier belt (8) by negative pressure, wherein at the end of the transport path (11) the data carriers (1) are transferred to the data carrier transfer device (4),
the transfer device (4) having a transfer roller (14) which is provided on the circumference with suction openings (13) and which is hydraulically connected to a vacuum source in such a way that data carriers (1) located on the outer casing of the transfer roller (14) can be sucked onto the outer casing by vacuum,
the transfer roller (14) having an access region (15) adjacent to the suction box (12) of the feed device (3) and an exit region (16) adjacent to the adjusting device (5) and spaced apart from the access region (15) by a certain angle, and
wherein, at the exit region (16) of the transfer roller (14), a data carrier (1) located there on the outer jacket of the transfer roller (14) can be transferred to the carrier web (2),
wherein an ejecting device is provided on the upper run (9) upstream of the data carrier transfer device (4) in the feed direction of the data carriers (1), by means of which device a data carrier (1) located on the upper run (9) can be removed from the upper run (9) in a controlled manner.

2. A device according to claim 1, **characterized in that**,
**in that** the ejection device is formed by an ejection section (17) which is present on the suction box (12) in the course of the transport path (11) formed by the upper run (9) and in which an overpressure, preferably an overpressure instead of the underpressure, can be optionally generated on the upper run (9) of the carrier belt (8), by means of which overpressure a data carrier (1) located here can be ejected from the upper run (9) in a controlled manner.

3. A device according to claim 1, **characterized in that**,
**in that** the ejection device has pivotable flaps on the carrier belt (8), it being possible for a data carrier (1) located on the upper run (9) to be ejected from the upper run (9) in a controlled manner by actuating an individual flap, or
**in that** the ejection device has, in a fixed position on the upper run (9), a pivotable flap between two carrier belts (8), it being possible for a data carrier (1) located at this position on the upper run (9) to be ejected from the upper run (9) in a controlled manner by actuating this flap.

4. A device according to claim 1, **characterized in that**,
**in that** at least one gripper and/or suction device is assigned to the carrier belt (8) in the course of the transport path (11) formed by the upper run (9) as a discharge device, by means of which gripper and/or suction device a data carrier (1) located on the upper run (9) of the carrier belt (8) can be removed from the upper run (9) in a controlled manner.

5. The device according to any one of claims 1 to 4, **characterized in that**,
**in that** a data carrier testing device (18) is arranged in the data carrier feed device (3) or in the feed direction of the data carriers (1) upstream of the data carrier feed device (3), by means of which device each individual data carrier (1) passing through there can be tested, and **in that**, by means of a control, a data carrier (1) which is detected as defective by the testing device (18) can be removed from the upper run (9), preferably at the ejection section (17).

6. The device according to any one of claims 1 to 5, **characterized in that**,
**in that** a transverse cutting device (19) is arranged in the feed direction of the data carriers (1) at the start of the data carrier feed device (3), by means of which transverse cutting device (19) the data carriers (1) running in continuously as a data carrier web (2) can be separated.

7. The device according to any one of claims 1 to 5, **characterized in that**,
**in that** a separating device (20) is arranged in the feed direction of the data carriers (1) at the start of the data carrier feed device (3), by means of which separating device (20) the data carriers (1), which are individually detachably attached to a continuous base web (21), can be separated from the base web (21) and deposited on the upper run (9) of the carrier belt (8).

8. The device according to any one of claims 1 to 7, **characterized in that**,
**in that** the transfer roller (14) of the data carrier transfer device (4) is at the same time the drive roller (6) of the data carrier feed device (3).

9. The device according to any one of claims 1 to 7, **characterized in that**,
**in that** the transfer roller (14) of the data carrier transfer device (4), together with a second deflection (22) arranged at a distance from the transfer roller (14) essentially horizontally counter to the feed direction of the data carriers (1) and with a second carrier belt (23) running around both of them, forms a second transport section (24) for the data carriers (1) which adjoins the first transport section (11) in the feed direction of the data carriers (1).

## Revendications

1. Dispositif de montage de supports de données (1) plans sur une bande de support (2) continue, comportant
un dispositif d'alimentation (3) pour supports de données,
un dispositif de transfert (4) pour supports de données et
un dispositif de réglage (5) de la bande support,
dans lequel le dispositif d'alimentation (3) comporte un rouleau d'entraînement (6), un déflecteur (7) disposé essentiellement horizontalement à distance du rouleau d'entraînement (6) et au moins une bande transporteuse (8) tournant autour du rouleau d'entraînement (6) et du déflecteur (7) pour alimenter les supports de données (1) au dispositif de transfert (4) pour supports de données,
dans lequel la bande transporteuse (8) comporte un brin supérieur (9) s'étendant essentiellement horizontalement dans la direction d'alimentation des supports de données (1) et un brin inférieur (10) s'étendant en dessous dans la direction opposée,
dans lequel le brin supérieur (9) forme un chemin de transport (11) pour le transport des supports de données (1) vers le dispositif de transfert (4) pour supports de données et est relié de manière hydraulique à une caisse d'aspiration (12) disposée en dessous de telle sorte que des supports de données (1) situés sur le brin supérieur (9) peuvent être aspirés sur la bande transporteuse (8) par dépression,
dans lequel à l'extrémité du chemin de transport (11), les supports de données (1) sont transférés au dispositif de transfert (4) pour supports de données,
dans lequel le dispositif de transfert (4) comporte un rouleau de transfert (14) situé sur la périphérie comportant des orifices d'aspiration (13), lequel est relié de manière hydraulique à une source de dépression de telle sorte que le support de données (1) situé sur l'enveloppe extérieure du rouleau de transfert (14) peut être aspiré sur la surface extérieure par dépression,
dans lequel le rouleau de transfert (14) comporte une zone d'accès (15) adjacente à la caisse d'aspiration (12) du dispositif d'alimentation (3) et une zone de sortie (16) espacée de la zone d'accès (15) d'un certain angle et adjacente au dispositif de réglage (5), et
dans lequel au niveau de la zone de sortie (16) du rouleau de transfert (14), un support de données (1) situé à cet endroit sur la surface extérieure du rouleau de transfert (14) peut être transféré sur la bande support (2),
dans lequel sur le brin supérieur (9), un dispositif d'éjection est situé dans la direction d'alimentation des supports de données (1) en amont du dispositif de transfert (4) pour supports de données, au moyen duquel un support de données (1) situé sur le brin supérieur (9) peut être retiré du brin supérieur (9) de manière commandée.

2. Dispositif selon la revendication 1, **caractérisé**
**en ce que** le dispositif d'éjection est formé par une section d'éjection (17) présente sur la caisse d'aspiration (12) au cours du chemin de transport (11) formé par le brin supérieur (9), dans laquelle une surpression, de préférence une surpression au lieu de dépression, peut être facultativement générée sur le brin supérieur (9) de la bande transporteuse (8), au moyen de laquelle un support de données (1) ici situé peut être éjecté du brin supérieur (9) de manière commandée.

3. Dispositif selon la revendication 1, **caractérisé**
**en ce que** le dispositif d'éjection comporte des volets pivotants sur la bande transporteuse (8), un support de données (1) situé sur le brin supérieur (9) pouvant être éjecté du brin supérieur (9) de manière commandée par activation d'un seul volet, ou
**en ce que** le dispositif d'éjection comporte un volet pivotant fixe sur le brin supérieur (9) entre deux bandes transporteuses (8), dans lequel un support de données (1) situé à cet endroit sur le brin supérieur (9) peut être éjecté du brin supérieur (9) de manière commandée par activation dudit volet.

4. Dispositif selon la revendication 1, **caractérisé**
**en ce qu'**au moins un dispositif de préhension et/ou d'aspiration est associé à la bande transporteuse (8) au cours du chemin de transport (11) formé par le brin supérieur (9) en tant que dispositif d'éjection, à travers lequel un support de données (1) situé sur le brin supérieur (9) de la bande transporteuse (8) du brin supérieur (9) est commandé amovible.

5. Dispositif selon l'une quelconque des revendications 1 à 4, **caractérisé**
**en ce que** dans le dispositif d'alimentation (3) en supports de données ou dans la direction d'alimentation du support de données (1) en amont du dispositif d'alimentation (3) en supports de données est disposé un dispositif de vérification (18) pour supports de données au moyen duquel chaque support de données (1) individuel passant par celui-ci peut être vérifié, et que, au moyen d'une commande, un support de données (1) déterminé comme défectueux par le dispositif de vérification (18) peut être retiré du brin supérieur (9), de préférence sur la section d'éjection (17).

6. Dispositif selon l'une quelconque des revendications 1 à 5, **caractérisé en ce que**
**en ce que** dans la direction d'alimentation des supports de données (1), au début du dispositif d'alimentation (3) en supports de données est disposé un dispositif de coupe transversale (19) au moyen duquel les supports de données (1) arrivant de manière inhérente en tant que bande de supports de données (2) peuvent être séparés.

7. Dispositif selon l'une quelconque des revendications 1 à 5, **caractérisé**
**en ce que** dans la direction d'alimentation des supports de données (1) au début du dispositif d'alimentation (3) en supports de données est disposé un dispositif de séparation (20) au moyen duquel les supports de données (1) montés de manière individuellement amovible à une bande de base (21) inhérente peuvent être séparés de la bande de base (21) et peuvent être placés sur le brin supérieur (9) de la bande transporteuse (8).

8. Dispositif selon l'une quelconque des revendications 1 à 7, **caractérisé**
**en ce que** le rouleau de transfert (14) du dispositif de transfert (4) pour supports de données est en même temps le rouleau d'entraînement (6) du dispositif d'alimentation (3) en supports de données.

9. Dispositif selon l'une quelconque des revendications 1 à 7, **caractérisé**
**en ce que** le rouleau de transfert (14) du dispositif de transfert (4) pour supports de données, conjointement avec un deuxième déflecteur (22) disposé essentiellement horizontalement à distance du rouleau de transfert (14) dans la direction contraire de la direction d'alimentation des supports de données (1) et avec une seconde bande transporteuse (23) s'étendant autour des deux, forme un second chemin de transport (24) pour les supports de données (1), lequel suit le premier chemin de transport (11) dans la direction d'alimentation des supports de données (1).
